# EUROPÄISCHE PATENTSCHRIFT

(11) **EP 1 485 523 B1**
(45) Veröffentlichungstag und Bekanntmachung des Hinweises auf die Patenterteilung: **17.05.2006**
(21) Anmeldenummer: 02799711.3
(22) Anmeldetag: 15.12.2002
(51) Int. Cl.: C30B 29/22, H01L 39/24, B32B 15/00

(54) **METALLBAND FÜR EPITAKTISCHE BESCHICHTUNGEN UND VERFAHREN ZU DESSEN HERSTELLUNG**
METAL STRIP FOR EPITAXIAL COATING AND METHOD FOR PRODUCTION THEREOF
BANDE DE METAL POUR REVETEMENTS EPITAXIAUX ET PROCEDE PERMETTANT DE LA PRODUIRE

(30) Priorität: 02.01.2002 DE 10200445
(43) Veröffentlichungstag der Anmeldung: 15.12.2004
(73) Patentinhaber: Leibniz-Institut für Festkörper- und Werkstoffforschung Dresden e.V., 01069 Dresden (DE); ThyssenKrupp VDM GmbH, 58791 Werdohl (DE)
(72) Erfinder: DE BOER, Bernd, 58762 Altena (DE); VADLAMANI, Sarma D-19-23, Chennai - 600 036 (IN); KLOEWER, Jutta, 58675 Hermer (DE)
(74) Vertreter: Rauschenbach, Dieter
(86) Internationale Anmeldenummer: PCT/DE2002/004663
(87) Internationale Veröffentlichungsnummer: WO 2003/060203

(56) Entgegenhaltungen:
- WO-A-00/58044
- US-A- 5 739 086
- US-A- 5 741 377
- US-A- 5 898 020
- US-A- 5 964 966
- US-A- 5 968 877
- US-B1- 6 180 570

## Beschreibung

### Technisches Gebiet

Die Erfindung betrifft ein aus einem Schichtverbund bestehendes Metallband für epitaktische Beschichtungen und ein Verfahren zu dessen Herstellung. Derartige Bänder können beispielsweise vorteilhaft als Trägerband für die Abscheidung biaxial texturierter Schichten aus YBa₂Cu₃Oₓ-Hochtemperatur-Supraleitermaterial verwendet werden. Derartige Supraleiter eignen sich besonders für Anwendungen in der Energietechnik.

### Stand der Technik

Es sind bereits Metallbänder auf der Basis von Ni, Cu und Ag bekannt, die sich für die epitaktische Beschichtung mit einer biaxial texturierten Schicht eignen (US 5 739 086; US 5 741 377; US 5 964 966; US 5 968 877). Sie werden durch Kaltwalzen mit einem Verformungsgrad über 95% und anschließende Rekristallisationsglühung hergestellt, wobei sich eine scharfe {001}<100> Textur (Würfeltextur) bildet.

Insbesondere an der Entwicklung von Substratmaterialien auf der Basis von Ni und Ag wird weltweit intensiv gearbeitet (J. E. Mathis et al., Jap. J. Appl. Phys. 37, 1998; T. A. Gladstone et al., Inst. Phys. Conf. Ser. No 167,1999). Bekannte Bestrebungen, die Festigkeit des Materials zu steigern, sind entweder durch Mischkristallhärtung, bei der eine Ni-Legierung mit typischerweise mehr als 5 % eines oder mehrerer Legierungselemente gewalzt und rekristallisiert wird, (US 5 964 966; G. Celentano et al., Int. Journal of Modern Physics B, 13, 1999, S. 1029; R. Nekkanti et al., Presentation at the Applied Supercond. Conf., Virginia Beach, Virginia, Sept. 17-22, 2000) oder durch Walzen und Rekristallisieren eines Verbundes aus Ni mit einem Material höherer Zugfestigkeit (T. Watanabe et al., Presentation at the Applied Supercond. Conf., Virginia Beach, Virginia, Sept. 17-22, 2000).

Bei der Mischkristallhärtung gibt es einen kritischen Legierungsgrad, oberhalb dem sich die Würfeltextur nicht mehr ausbilden lässt. Dieses Phänomen ist für Messinglegierungen (Cu-Zn-Legierungen mit steigendem Zn-Gehalt) intensiv untersucht worden und scheint allgemeine Gültigkeit zu haben (H. Hu et al., Trans. AIME, 227, 1963, S. 627; G. Wassermann, J. Grewen: Texturen metallischer Werkstoffe, Springer-Verlag Berlin/Göttingen/Heidelberg). Da die Festigkeit stetig mit der Legierungskonzentration steigt, ist damit auch eine maximale Festigkeit verbunden. Die zweite Einschränkung ist die hohe Festigkeit des Materials bereits bei der Walzumformung. Dadurch treten bei dem notwendigerweise hohen Umformgrad sehr große Walzkräfte auf, wodurch zum einen erhöhte Ansprüche an das Walzwerk gestellt werden müssen und zum anderen es technisch schwieriger wird, die außerordentlich homogene Walzverformung durchzuführen, die für die Bildung der notwendigen hochgradigen Würfeltextur nötig ist.

Bei der Festigkeitssteigerung durch Walzen eines Verbundes gibt es ebenfalls das Problem der hohen Walzkräfte bei der starken Umformung eines sehr festen Werkstoffs. Auf Grund der Unterschiede in den mechanischen Eigenschaften der beiden, den Verbund bildenden Materialien treten beim Walzen Inhomogenitäten in der Verformungsmikrostruktur auf, welche die beim Rekristallisationsprozess erreichbare Würfeltexturqualität vermindern.

Eine deutlich höhere Festigkeit als Mischkristalllegierungen haben intermetallische Phasen. Diese sind jedoch i.a. spröde, wodurch sie sich nicht zu einem dünnen Band mit ausgeprägter Würfeltextur prozessieren lassen.

Insbesondere von sogenannten intermetallischen y'- und y"-Phasen (Ni₃Al, Ni₃Ti, Ni₃Nb) ist es bekannt, dass die Festigkeit nicht wie bei Mischkristallen mit zunehmender Temperatur abnimmt, sondern sogar noch steigt. Dadurch hat ein Band, das durch solche Phasen verstärkt ist, gerade bei den kritischen hohen Temperaturen (> 600°C) die während einer Beschichtung auftreten, eine gegenüber herkömmlichen Bändern stark erhöhte Festigkeit.

### Darstellung der Erfindung

Der Erfindung liegt die Aufgabe zugrunde, ein Metallband für epitaktische Beschichtungen zu schaffen, das eine besonders hohe Festigkeit aufweist. Eingeschlossen in die Aufgabe ist die Entwicklung eines Verfahrens, welches eine technologisch unproblematische Herstellung solcher hochfester Metallbänder ermöglicht.

Die Aufgabe wird mit einem aus einem Schichtverbund bestehenden Metallband dadurch gelöst, dass der Schichtverbund aus mindestens einer biaxial texturierten Basisschicht der Metalle Ni, Cu, Ag oder deren Legierungen und mindestens einer weiteren metallischen Schicht besteht, wobei die einzelnen weiteren metallischen Schichten aus einer oder mehreren intermetallischen Phasen oder aus einem Metall bestehen, in dem eine oder mehrere intermetallische Phasen enthalten sind.

Gemäß einer ersten zweckmäßigen Ausgestaltung der Erfindung bestehen im Falle biaxial texturierter Basisschichten aus Ni oder Ni-Legierungen die einzelnen weiteren metallischen Schichten aus intermetallischen Phasen des Basisschichtmetalls mit wenigstens einem der Metalle Al, Ta, Nb, Ti oder deren Legierungen.

Gemäß einer zweiten zweckmäßigen Ausgestaltung der Erfindung bestehen im Falle biaxial texturierter Basisschichten aus Ni oder Ni-Legierungen die einzelnen weiteren metallischen Schichten aus wenigstens einem der Metalle Al, Ta, Nb, Ti oder deren Legierungen mit darin enthaltenen intermetallischen Phasen der Metalle Al, Ta, Nb, Ti oder deren Legierungen mit dem Basisschichtmetall.

Die intermetallischen Phasen können in zweckmäßiger Weise aus NiAl, Ni₃Al, Al₃Ni₂, Al₃Ni, NiTa, NiTa₂, Ni₃Ta Ni₃Nb, und/oder Ni₆Nb₇ bestehen.

Gemäß einer weiteren zweckmäßigen Ausgestaltung der Erfindung bestehen im Falle biaxial texturierter Basisschichten aus Cu oder Cu-Legierungen die einzelnen weiteren metallischen Schichten aus intermetallischen Phasen von Zn und dem Cu oder der Cu-Legierung.

Im Falle biaxial texturierter Basisschichten aus Cu oder Cu-Legierungen können die einzelnen weiteren metallischen Schichten auch aus Zn mit darin enthaltenen intermetallischen Phasen des Cu oder der Cu-Legierung mit dem Zn bestehen.

Die intermetallischen Phasen des Cu oder der Cu-Legierung mit dem Zn sind dabei β- und/oder γ-Messing.

Gemäß einer weiteren zweckmäßigen Ausgestaltung der Erfindung bestehen im Falle biaxial texturierter Basisschichten aus Ag oder Ag-Legierungen die einzelnen weiteren metallischen Schichten aus intermetallischen Phasen von Nd und dem Ag oder der Ag-Legierung.

Im Falle biaxial texturierter Basisschichten aus Ag oder Ag-Legierungen können die einzelnen weiteren metallischen Schichten auch aus Nd mit darin enthaltenen intermetallischen Phasen des Ag oder der Ag-Legierung mit dem Nd bestehen.

Die intermetallischen Phasen des Ag oder der Ag-Legierung mit dem Nd bestehen dabei aus Ag₅₂Nd₁₄, Ag₂Nd und/oder AgNd.

Gemäß einer vorteilhaften Ausgestaltung der Erfindung besteht der Schichtverbund aus zwei der biaxial texturierten Basisschichten und einer der weiteren metallischen Schichten,
wobei die weitere metallische Schicht zwischen den biaxial texturierten Schichten angeordnet ist.

Zur Herstellung solcher Metallbänder beinhaltet die Erfindung ein Verfahren, bei dem zunächst ein Schichtverbund erzeugt wird, der aus mindestens einer für eine biaxiale Texturierung geeigneten Schicht der Metalle Ni, Cu, Ag oder deren Legierung und mindestens einer weiteren metallischen Schicht besteht. In den weiteren metallischen Schichten muss dabei wenigstens ein Element enthalten sein, das mit den Elementen der zur biaxialen Texturierung geeigneten Schichten intermetallische Phasen bilden kann.

Danach wird dieser Schichtverbund mit einem Umformgrad von mindestens 90% zu einem Band gewalzt. Schließlich werden mittels Wärmebehandlung des Bandes zwischen 300°C und 1100°C die gewünschte Textur in den für eine biaxiale Texturierung geeigneten Schichten und in den weiteren Schichten durch Interdiffusion über die Grenzflächen der verbundenen Schichten intermetallische Phasen ausgebildet.

Der Schichtverbund wird in zweckmäßiger Weise durch Plattieren erzeugt und das Walzen des Schichtverbundes zu einem Band wird mit einem Umformgrad von mindestens 95% durchgeführt. Für die Wärmehandlung des Bandes sind Temperaturen zwischen 500°C und 900°C besonders geeignet.

Eine Modifikation des erfindungsgemäßen Verfahrens besteht darin, dass zunächst durch Walzen und Rekristallisieren ein biaxial texturiertes Band aus Ni, Cu, Ag oder deren Legierungen hergestellt wird. Dieses Band wird anschließend mit mindestens einer weiteren metallischen Phase beschichtet, welche wenigstens ein Metall enthält, das mit den Elementen im biaxial texturierten Band intermetallische Phasen bilden kann. Als Beschichtungsmethoden sind beispielsweise elektrolytische, chemische oder auch Abscheidungen aus der Dampfphase möglich. Während einer nachfolgenden Wärmebehandlung bildet sich ausgehend von der Grenzschicht die festigende intermetallische Phase aus.

Als Alternative zur Beschichtung ist es auch möglich, sofern der Schmelzpunkt des biaxial texturierten Bandes deutlich oberhalb der weiteren metallischen Phase liegt, das biaxial texturierte Band einseitig mit der weiteren metallischen Phase in flüssiger Form zu benetzen, aus der dann die Diffusion in das biaxial texturierte Band stattfindet, so dass sich die intermetallischen Phasen ausgehend von der Oberfläche des biaxial texturierten Bandes bilden.

Mit dem erfindungsgemäßen Verfahren lassen sich in relativ einfacher Weise hochfeste, biaxial texturierte metallische Bänder herstellen. Dabei ist von besonderem Vorteil, dass die Bänder für die Prozessstufen der Umformung noch eine günstige niedrige Festigkeit und hohe Duktilität aufweisen, da die hochfesten, intermetallischen Phasen erst bei der abschließenden Glühbehandlung im Band gebildet werden. Durch die unterschiedliche Kinetik der Prozesse Rekristallisation und Diffusion wird die Würfeltexturbildung nicht beeinträchtigt.

Die erfindungsgemäßen Bänder eignen sich besonders als Trägerband für die Abscheidung biaxial texturierter Schichten aus YBa₂Cu₃Oₓ-Hochtemperatur-Supraleitermaterial. Derartige Supraleiter können vorteilhaft in der Energietechnik eingesetzt werden.

### Wege zur Ausführung der Erfindung

Nachstehend ist die Erfindung anhand von Ausführungsbeispielen näher erläutert.

### Beispiel 1

Durch Walzplattieren wird ein aus drei Schichten bestehender Schichtverbund aus den Metallen Ni und Al in der Schichtfolge Ni/Al/Ni hergestellt. Die Ni-Schichten haben eine Dicke von 1,5 mm, die Al Schicht von 0,5 mm. Dieser Schichtverbund wird zu einem 80 µm dicken Band gewalzt. Das Band wird anschließend bei einer Temperatur von 600°C in reduzierender Atmosphäre mehrere Stunden ausgelagert. Innerhalb der ersten Minuten dieser Wärmebehandlung rekristallisiert das Band. Im weiteren Verlauf dieser Wärmebehandlung entstehen und wachsen an den Grenzschichten NiAl-Phasen unterschiedlicher Stöchiometrie.

Das fertige Band weist an der Oberfläche eine hochgradige Würfeltextur auf und eignet sich so für eine beidseitige epitaktische Beschichtung mit einer biaxial texturierten Schicht.

Die Streckgrenze des Bandes bei Raumtemperatur liegt bei 100 MPa und ändert sich nicht bis zu einer Temperatur von 600°C. Dadurch weist dieses Material bei der Beschichtungstemperatur gegenüber herkömmlichen, insbesondere gegenüber mischkristallgehärteten Bändern eine stark erhöhte Festigkeit auf.

### Beispiel 2

Durch Walzplattieren wird ein aus drei Schichten bestehender Schichtverbund aus den Metallen Ni und Nb in der Schichtfolge Ni/Nb/Ni hergestellt. Die Ni-Schichten haben eine Dicke von 1,5 mm, die Nb Schicht von 0,5 mm. Dieser Schichtverbund wird zu einem 40 µm dicken Band gewalzt, das anschließend bei einer Temperatur von 900°C in reduzierender Atmosphäre 1 Stunde ausgelagert wird. Innerhalb der ersten Sekunden dieser Glühung rekristallisiert das Band. Im weiteren Verlauf der Glühung entstehen und wachsen an den Grenzschichten NiNb-Phasen unterschiedlicher Stöchiometrie.

Das fertige Band weist an der Oberfläche eine hochgradige Würfeltextur auf und eignet sich ebenfalls für eine beidseitige epitaktische Beschichtung mit einer biaxial texturierten Schicht.

Die Streckgrenze des Bandes bei Raumtemperatur liegt bei 85 MPa und ändert sich nicht bis zu einer Temperatur von 600°C. Dadurch weist dieses Material bei der Beschichtungstemperatur gegenüber herkömmlichen, insbesondere gegenüber mischkristallgehärteten Bändern eine stark erhöhte Festigkeit auf.

### Beispiel 3

Ein durch Walzen und Rekristallisieren hergestelltes 40 µm dickes, biaxial texturiertes Band aus reinem Ni wird auf eine Temperatur von 800°C erwärmt und auf der nicht zu beschichtenden Seite mit einer 10 µm dicken Al-Folie belegt. Infolge der Wärmeeinwirkung schmilzt die Al-Folie und das Al diffundiert in das Ni ein, so dass sich durch Interdiffusion ausgehend von der Oberfläche des Ni-Bandes intermetallische NiAl-Phasen unterschiedlicher Stöchiometrie bilden.

Die Streckgrenze des Bandes bei Raumtemperatur liegt bei 90 MPa und ändert sich nicht bis zu einer Temperatur von 600°C. Dadurch weist dieses Material bei der Beschichtungstemperatur gegenüber herkömmlichen, insbesondere gegenüber mischkristallgehärteten Bändern eine stark erhöhte Festigkeit auf.

### Beispiel 4

Durch Walzplattieren wird ein aus drei Schichten bestehender Schichtverbund aus den Metallen Cu und Zn in der Schichtfolge Cu/Zn/Cu hergestellt. Die Cu-Schichten haben eine Dicke von 1,5 mm, die Zn-Schicht eine Dicke von 0,7 mm. Dieser Schichtverbund wird zu einem 50 µm dünnen Band gewalzt. Das Band wird anschließend mit 30 K/min auf 800 °C aufgeheizt und dort weitere 60 min gehalten. Während dieser Glühung bildet sich zunächst eine scharfe Würfeltextur und anschließend, ausgehend von den Cu-Zn-Grenzflächen, Messingphasen verschiedener Stöchiometrien aus.

Das fertige Band weist an den Oberflächen eine hochgradige Würfeltextur auf und eignet sich so für eine beidseitige epitaktische Beschichtung mit einer biaxialen texturierten Schicht. Die Streckgrenze des Bandes bei Raumtemperatur liegt bei 80 MPa und fällt mit steigender Temperatur auf 30 MPa bei 750 °C ab. Dadurch ist das Band deutlich fester als andere Cu-Legierungbänder mit vergleichbar starker Ausprägung einer biaxialen Textur.

## Patentansprüche

1. Metallband für epitaktische Beschichtungen, bestehend aus einem Schichtverbund, der aus mindestens einer biaxial texturierten Basisschicht der Metalle Ni, Cu, Ag oder deren Legierungen und mindestens einer weiteren metallischen Schicht besteht, **dadurch gekennzeichnet, dass**, die einzelnen weiteren metallischen Schichten aus einer oder mehreren intermetallischen Phasen oder aus einem Metall bestehen, in dem eine oder mehrere intermetallische Phasen enthalten sind.

2. Metallband nach Anspruch 1, **dadurch gekennzeichnet, dass** im Falle biaxial texturierter Basisschichten aus Ni oder Ni-Legierungen die einzelnen weiteren metallischen Schichten aus intermetallischen Phasen des Basisschichtmetalls mit wenigstens einem der Metalle Al, Ta, Nb, Ti oder deren Legierungen bestehen.

3. Metallband nach Anspruch 1, **dadurch gekennzeichnet, dass** im Falle biaxial texturierter Basisschichten aus Ni oder Ni-Legierungen die einzelnen weiteren metallischen Schichten aus wenigstens einem der Metalle Al, Ta, Nb, Ti oder deren Legierungen mit darin enthaltenen intermetallischen Phasen der Metalle Al, Ta, Nb, Ti oder deren Legierungen mit dem Basisschichtmetall bestehen.

4. Metallband nach Anspruch 2 oder 3, **dadurch gekennzeichnet, dass** die intermetallischen Phasen aus NiAl, Ni₃Al, Al₃Ni₂, Al₃Ni, NiTa, NiTa₂, Ni₃Ta Ni₃Nb, und/oder Ni₆Nb₇ bestehen.

5. Metallband nach Anspruch 1, **dadurch gekennzeichnet, dass** im Falle biaxial texturierter Basisschichten aus Cu oder Cu-Legierungen die einzelnen weiteren metallischen Schichten aus intermetallischen Phasen von Zn und dem Cu oder der Cu-Legierung bestehen.

6. Metallband nach Anspruch 1, **dadurch gekennzeichnet, dass** im Falle biaxial texturierter Basisschichten aus Cu oder Cu-Legierungen die einzelnen weiteren metallischen Schichten aus Zn mit darin enthaltenen intermetallischen Phasen des Cu oder der Cu-Legierung mit dem Zn bestehen.

7. Metallband nach Anspruch 5 oder 6, **dadurch gekennzeichnet, dass** die intermetallischen Phasen des Cu oder der Cu-Legierung mit dem Zn aus β- und/oder γ-Messing bestehen.

8. Metallband nach Anspruch 1, **dadurch gekennzeichnet, dass** im Falle biaxial texturierter Basisschichten aus Ag oder Ag-Legierungen die einzelnen weiteren metallischen Schichten aus intermetallischen Phasen von Nd und dem Ag oder der Ag-Legierung bestehen.

9. Metallband nach Anspruch 1, **dadurch gekennzeichnet, dass** im Falle biaxial texturierter Basisschichten aus Ag oder Ag-Legierungen die einzelnen weiteren metallischen Schichten aus Nd mit darin enthaltenen intermetallischen Phasen des Ag oder der Ag-Legierung mit dem Nd bestehen.

10. Metallband nach Anspruch 8 oder 9, **dadurch gekennzeichnet, dass** die intermetallischen Phasen des Ag oder der Ag-Legierung mit dem Nd aus Ag₅₂Nd₁₄, Ag₂Nd und/oder AgNd bestehen.

11. Metallband nach Anspruch 1, **dadurch gekennzeichnet, dass** der Schichtverbund aus zwei der biaxial texturierten Basisschichten und einer der weiteren metallischen Schichten besteht, wobei die weitere metallische Schicht zwischen den biaxial texturierten Schichten angeordnet ist.

12. Verfahren zur Herstellung eines Metallbandes nach einem der Ansprüche 1 bis 11, **dadurch gekennzeichnet, dass** zunächst ein Schichtverbund erzeugt wird, der aus mindestens einer für eine biaxiale Texturierung geeigneten Schicht der Metalle Ni, Cu, Ag oder deren Legierung und mindestens einer weiteren metallischen Schicht besteht, wobei in den weiteren metallischen Schichten wenigstens ein Element enthalten ist, das mit den Elementen der zur biaxialen Texturierung geeigneten Schichten intermetallische Phasen bilden kann, dass danach dieser Schichtverbund mit einem Umformgrad von mindestens 90% zu einem Band gewalzt wird, und dass schließlich mittels Wärmebehandlung des Bandes zwischen 300°C und 1100°C die gewünschte Textur in den für eine biaxiale Texturierung geeigneten Schichten und in den weiteren Schichten durch Interdiffusion über die Grenzflächen der verbundenen Schichten intermetallische Phasen ausgebildet werden.

13. Verfahren nach Anspruch 12, **dadurch gekennzeichnet, dass** der Schichtverbund durch Plattieren hergestellt wird.

14. Verfahren nach Anspruch 12, **dadurch gekennzeichnet, dass** das Walzen des Schichtverbundes mit einem Umformgrad von mindestens 95% durchgeführt wird.

15. Verfahren zur Herstellung eines Metallbandes nach einem der Ansprüche 1 bis 11, **dadurch gekennzeichnet, dass** zunächst durch Walzen und Rekristallisieren ein biaxial texturiertes Band aus Ni, Cu, Ag oder deren Legierungen hergestellt wird, dass dieses Band anschließend mit mindestens einer weiteren metallischen Phase beschichtet wird, welche wenigstens ein Metall enthält, das mit den Elementen im biaxial texturierten Band intermetallische Phasen bilden kann, und dass während einer nachfolgenden Wärmebehandlung -ausgehend von der Grenzschicht die festigende intermetallische Phase ausgebildet wird.

16. Verfahren zur Herstellung eines Metallbandes nach Anspruch 15, **dadurch gekennzeichnet, dass** für die Beschichtung elektrolytische, chemische oder auch Abscheidungen aus der Dampfphase angewandt werden.

17. Verfahren nach Anspruch 12 oder 15, **dadurch gekennzeichnet, dass** die Wärmehandlung bei Temperaturen zwischen 500°C und 900°C durchgeführt wird.

18. Verfahren zur Herstellung eines Metallbandes nach Anspruch 15, **dadurch gekennzeichnet, dass**, sofern der Schmelzpunkt des biaxial texturierten Bandes deutlich oberhalb der weiteren metallischen Phase liegt, das biaxial texturierte Band einseitig mit der weiteren metallischen Phase in flüssiger Form benetzt wird.

19. Verwendung des Metallbandes nach einem der Ansprüche 1 bis 11 als Trägerband für die Abscheidung biaxial texturierter Schichten aus YBa₂Cu₃Oₓ-Hochtemperatur-Supraleitermaterial zur Herstellung bandförmiger Hochtemperatur-Supraleiter.

20. Verwendung der gemäß Anspruch 19 hergestellten Hochtemperatur-Supraleiter in der Energietechnik.

## Claims

1. Metal strip for epitaxial coatings, comprising a layer composite which consists of at least one biaxially textured base layer of the metals Ni, Cu, Ag or their alloys and at least one further metallic layer, **characterized in that** the individual further metallic layers consist of one or more intermetallic phases or of a metal containing one or more intermetallic phases.

2. Metal strip according to Claim 1, **characterized in that** in the case of biaxially textured base layers made from Ni or Ni alloys, the individual further metallic layers consist of intermetallic phases of the base layer metal with at least one of the metals Al, Ta, Nb, Ti or alloys thereof.

3. Metal strip according to Claim 1, **characterized in that**, in the case of biaxially textured base layers made from Ni or Ni alloys, the individual further metallic layers consist of at least one of the metals Al, Ta, Nb, Ti or alloys thereof containing intermetallic phases of the metals Al, Ta, Nb, Ti or alloys thereof with the base layer metal.

4. Metal strip according to Claim 2 or 3, **characterized in that** the intermetallic phases consist of NiAl, Ni₃Al, Al₃Ni₂, Al₃Ni, NiTa, NiTa₂, Ni₃Ta, Ni₃Nb, and/or Ni₆Nb₇.

5. Metal strip according to Claim 1, **characterized in that** in the case of biaxially textured base layers made from Cu or Cu alloys, the individual further metallic layers consist of intermetallic phases of Zn and the Cu or Cu alloy.

6. Metal strip according to Claim 1, **characterized in that**, in the case of biaxially textured base layers made from Cu or Cu alloys, the individual further metallic layers consist of Zn containing intermetallic phases of the Cu or Cu alloy with the Zn.

7. Metal strip according to Claim 5 or 6, **characterized in that** the intermetallic phases of the Cu or Cu alloy with the Zn consist of β- and/or γ-brass.

8. Metal strip according to Claim 1, **characterized in that**, in the case of biaxially textured base layers made from Ag or Ag alloys, the individual further metallic layers consist of intermetallic phases of Nd and the Ag or Ag alloy.

9. Metal strip according to Claim 1, **characterized in that**, in the case of biaxially textured base layers made from Ag or Ag alloys, the individual further metallic layers consist of Nd containing intermetallic phases of the Ag or Ag alloy with the Nd.

10. Metal strip according to Claim 8 or 9, **characterized in that** the intermetallic phases of the Ag or Ag alloy with the Nd consist of Ag₅₂Nd₁₄, Ag₂Nd and/or AgNd.

11. Metal strip according to Claim 1, **characterized in that** the layer composite comprises two of the biaxially textured base layers and one of the further metallic layers, with the further metallic layer being arranged between the biaxially textured layers.

12. Process for producing a metal strip according to one of Claims 1 to 11, **characterized in that** first of all a layer composite, which comprises at least one layer of the metals Ni, Cu, Ag or their alloy which is suitable for biaxial texturing and at least one further metallic layer, is produced, at least one element which can form intermetallic phases with the elements of the layers suitable for biaxial texturing being contained in the further metallic layers, **in that** this layer composite is then rolled with a degree of deformation of at least 90% to form a strip, and **in that** finally the desired texture is formed in the layers suitable for biaxial texturing by means of heat treatment of the strip at between 300°C and 1100°C, and intermetallic phases are formed in the further layers by interdiffusion via the interfaces of the joined layers.

13. Process according to Claim 12, **characterized in that** the layer composite is produced by plating.

14. Process according to Claim 12, **characterized in that** the rolling of the layer composite is carried out with a degree of deformation of at least 95%.

15. Process for producing a metal strip according to one of Claims 1 to 11, **characterized in that** first of all a biaxially textured strip of Ni, Cu, Ag or alloys thereof is produced by rolling and recrystallizing, **in that** this strip is then coated with at least one further metallic phase which contains at least one metal that can form intermetallic phases with the elements in the biaxially textured strip, and **in that** during a subsequent heat treatment the strengthening intermetallic phase is formed starting from the interfacial layer.

16. Process for producing a metal strip according to Claim 15, **characterized in that** electrolytic depositions, chemical depositions or vapour depositions are used for the coating.

17. Process according to Claim 12 or 15, **characterized in that** the heat treatment is carried out at temperatures between 500°C and 900°C.

18. Process for producing a metal strip according to Claim 15, **characterized in that**, if the melting point of the biaxially textured strip is well above that of the further metallic phase, the biaxially textured strip is wetted on one side with the further metallic phase in liquid form.

19. Use of the metal strip according to one of Claims 1 to 11 as a carrier strip for the deposition of biaxially textured layers of YBa₂Cu₃Oₓ high-temperature superconductor material for the production of high-temperature superconductors in strip form.

20. Use of the high-temperature superconductors produced as described in Claim 19 in power engineering.

## Revendications

1. Feuillard métallique pour revêtements épitactiques, constitué d'une couche composite constituée d'au moins une couche de base biaxialement texturée des métaux Ni, Cu, Ag ou de leurs alliages et d'au moins une autre couche métallique, **caractérisé en ce que** chacune des autres couches métalliques est constituée d'une ou de plusieurs phases intermétalliques ou d'un métal qui contient une ou plusieurs phases intermétalliques.

2. Feuillard métallique selon la revendication 1, **caractérisé en ce que** lorsque les couches de base biaxialement texturées sont constituées de Ni ou d'alliage de Ni, chacune des autres couches métalliques est constituée de phases intermétalliques du métal de la couche de base et d'au moins l'un des métaux Al, Ta, Nb, Ti ou leurs alliages.

3. Feuillard métallique selon la revendication 1, **caractérisé en ce que** lorsque les couches de base biaxialement texturées sont constituées de Ni ou d'alliage de Ni, chacune des autres couches métalliques est constituée d'au moins l'une des métaux Al, Ta, Nb, Ti ou de leurs alliages et contient des phases intermétalliques des métaux Al, Ta, Nb, Ti ou de leurs alliages avec le métal de la couche de base.

4. Feuillard métallique selon les revendications 2 ou 3, **caractérisé en ce que** les phases intermétalliques des métaux sont constituées de NiAl, Ni₃Al, Al₃Ni₂, Al₃Ni, NiTa, NiTa₂, Ni₃Ta, Ni₃Nb et/ou Ni₆Nb₇.

5. Feuillard métallique selon la revendication 1, **caractérisé en ce que** lorsque les couches de base texturées biaxialement sont constituées de Cu ou d'alliage de Cu, chacune des autres couches métalliques est constituée de phases intermétalliques de Zn et du Cu ou de l'alliage de Cu.

6. Feuillard métallique selon la revendication 1, **caractérisé en ce que** lorsque les couches de base biaxialement texturées sont constituées de Cu ou d'alliage de Cu, chacune des autres couches métalliques est constituée de Zn qui contient des phases intermétalliques du Cu ou de l'alliage de Cu avec le Zn.

7. Feuillard métallique selon les revendications 5 ou 6, **caractérisé en ce que** les phases intermétalliques du Cu ou de l'alliage de Cu avec le Zn sont constituées de laiton β et/ou de laiton γ.

8. Feuillard métallique selon la revendication 1, **caractérisé en ce que** lorsque les couches de base biaxialement texturées sont constituées d'Ag ou d'alliage d'Ag, chacune des autres couches métalliques est constituée de phases intermétalliques de Nd et d'Ag ou de l'alliage d'Ag.

9. Feuillard métallique selon la revendication 1, **caractérisé en ce que** lorsque les couches de base biaxialement texturées sont constituées d'Ag ou d'alliage d'Ag, chacune des autres couches métalliques est constituée de Nd avec des phases intermétalliques d'Ag ou de l'alliage d'Ag avec le Nd.

10. Feuillard métallique selon les revendications 8 ou 9, **caractérisé en ce que** les phases intermétalliques de l'Ag ou de l'alliage d'Ag avec le Nd sont constituées de Ag₅₂Nd₁₄, d'Ag₂Nd et/ou d'AgNd.

11. Feuillard métallique selon la revendication 1, **caractérisé en ce que** la couche composite est constituée de deux des couches de base biaxialement texturées et d'une des autres couches métalliques agencée entre les couches biaxialement texturées.

12. Procédé de fabrication d'un feuillard métallique selon l'une des revendications 1 à 11, **caractérisé en ce que** l'on produit tout d'abord une couche composite constituée d'au moins une couche des métaux Ni, Cu, Ag ou de leurs alliages, qui convient pour recevoir une texturation biaxiale et d'au moins une autre couche métallique qui contient au moins un élément qui peut former des phases intermétalliques avec les éléments des couches qui conviennent pour recevoir une texturation biaxiale, **en ce qu'**on lamine ensuite cette couche composite à un taux de déformation d'au moins 90 % pour obtenir un feuillard et **en ce qu'**en traitant thermiquement le feuillard entre 300°C et 1 100°C, on obtient finalement la texture souhaitée des couches qui conviennent pour recevoir une texturation biaxiale et des autres couches par interdiffusion à travers la surface frontière entre les couches de phases intermétalliques reliées.

13. Procédé selon la revendication 12, **caractérisé en ce que** l'on fabrique la couche composite par placage.

14. Procédé selon la revendication 12, **caractérisé en ce que** l'on lamine la couche composite à un taux de déformation d'au moins 95 %.

15. Procédé de fabrication d'un feuillard métallique selon l'une des revendications 1 à 11, **caractérisé en ce que**, par laminage et recristallisation, on fabrique tout d'abord un feuillard biaxialement texturé en Ni, Cu, Ag ou leurs alliages, **en ce qu'**on applique sur ce feuillard au moins une autre phase métallique qui contient au moins un métal apte à former des phases intermétalliques avec les éléments du feuillard biaxialement texturé et **en ce que**, lors d'un traitement thermique qui suit, on forme la phase intermétallique de renforcement à partir de la couche frontière.

16. Procédé de fabrication d'un feuillard métallique selon la revendication 15, **caractérisé en ce que** pour le revêtement, on utilise des dépôts électrolytiques, chimiques ou par phase vapeur.

17. Procédé selon les revendications 12 ou 15, **caractérisé en ce que** le traitement thermique a lieu à des températures comprises entre 500°C et 900°C.

18. Procédé de fabrication d'un feuillard métallique selon la revendication 15, **caractérisé en ce que** si le point de fusion du feuillard texturé biaxialement est nettement supérieur à celui de l'autre phase métallique, on mouille l'un des côtés du feuillard biaxialement texturé au moyen de l'autre phase métallique liquide.

19. Utilisation du feuillard métallique selon l'une des revendications 1 à 11 comme feuillard de support pour le dépôt de couches texturées biaxialement et constituées d'un matériau en YBa₂Cu₃Oₓ supraconducteur à haute température pour fabriquer des feuillards supraconducteurs à haute température.

20. Utilisation du supraconducteur à haute température fabriqué selon la revendication 19 dans la technologie de l'énergie.
